# EUROPEAN PATENT APPLICATION

(11) **EP 1 614 713 A1**
(43) Date of publication of application: **11.01.2006**
(21) Application number: 03719121.0
(22) Date of filing: 17.04.2003
(51) Int. Cl.: C08L 63/00, C08L 67/00, C08J 5/24

(54) **FLAME-RETARDED EPOXY RESIN COMPOSITION, PREPREGS CONTAINING THE SAME, LAMINATED SHEETS AND PRINTED WIRING BOARDS**

(71) Applicant: Goo Chemical Co., Ltd., Uji-shi, Kyoto 611-0043 (JP)
(72) Inventor: OSHIMA, Maki, c/o Goo Chemical Co., Ltd., Uji-shi, Kyoto 611-0043 (JP); INOBE, Mototaka, c/o Goo Chemical Co., Ltd., Uji-shi, Kyoto 611-0043 (JP); KINOSHITA, Koichiro, c/o Goo Chemical Co., Ltd., Uji-shi, Kyoto 611-0043 (JP)
(74) Representative: Appelt, Christian W.
(86) International application number: PCT/JP2003/004906
(87) International publication number: WO 2004/092265

(57) **Abstract**

A flame retardant epoxy resin composition comprises a phosphorus atom-containing flame retardant polyester resin in addition to essential components of an epoxy resin and a curing agent. The phosphorus atom-containing flame retardant polyester resin is obtained by a condensation reaction or a polycondensation reaction of a reactive phosphorus-containing compound represented by the structural formula (I). By use of the phosphorus atom-containing flame retardant polyester resin as a halogen-free flame retardant, it is possible to achieve flame retardancy, reduce an amount of poisonous gas emitted when ignited, and improve moldability. In addition, a cured product of this epoxy resin composition is excellent in heat resistance, water resistance, chemical resistance, solder resistance, moisture resistance and tracking resistance as well as the flame retardancy.

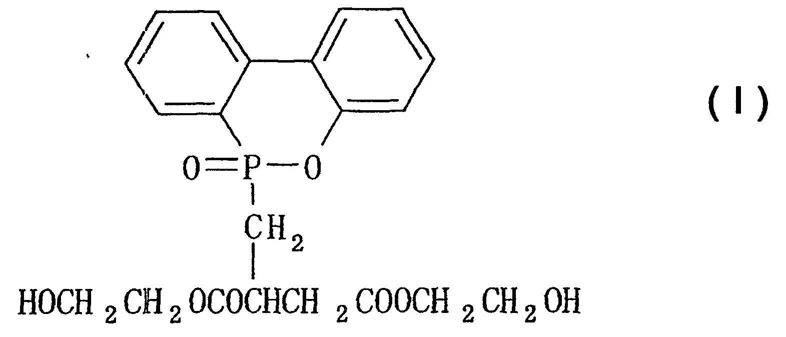

## Description

### TECHNICAL FIELD

The present invention relates to a flame retardant epoxy resin composition having high flame resistance, which emits a little amount of poisonous gas when ignited, and prepregs, laminates and printed wiring boards, which are produced by use of the same epoxy resin composition.

### BACKGROUND ART

Epoxy resin having excellent performance such as heat resistance, adhesion and electric properties (electric insulation) has been widely used as a material for various electric and electronic parts.

In the application of electric laminates typified by glass epoxy laminates for printed wiring boards, high flame retardancy ("V-0" in UL-94 flammability test) is desired. For this purpose, a halogen containing compound such as a brominated epoxy resin is usually used. For example, it is disclosed in Japanese Patent Early Publications [kokai] No. 5-9394, No. 9-125037, and No. 9-283876 that a resin composition comprising an epoxy resin containing the brominated epoxy resin as the main component and an epoxy resin curing agent such as dicyandiamide and phenol compounds are used to manufacture an epoxy resin laminate for printed circuit board.

However, the use of such a halogen containing compound is recently focused as a cause of the environmental destruction typified by dioxin. In addition, dissociation of halogen under high temperature condition has a bad influence on long-term electric reliability. Therefore, it is strongly desired to reduce the amount used of the halogen containing compound, or develop a flame retardant using an alternative compound for the halogen containing compound or a new method of imparting flame retardancy to the resin composition.

As a substitute technique for the flame retardancy imparting method using the halogen containing compound, Japanese Patent Early Publication [kokai] No. 10-193516 discloses to use a phosphoric ester compound as the flame retardant.

However, when the phosphoric ester compound is used as the flame retardant, a large amount of the flame retardant is needed to achieve high frame retardancy (for example, "V-0" in UL-94 flammability test). This leads to deterioration in properties of the resultant molded article such as heat resistance, water resistance, and chemical resistance to acid and alkali.

### SUMMARY OF THE INVENTION

Therefore, a primary concern of the present invention is to provide a flame retardant epoxy resin composition, which has the capability of reducing an amount of poisonous gas emitted when ignited, and imparting excellent flame retardancy, heat resistance, water resistance, chemical resistance as well as solder resistance, moisture resistance and tracking resistance to a molded article thereof.

That is, the flame retardant epoxy resin composition of the present invention comprises an epoxy resin (A), curing agent (B) and a phosphorus atom-containing flame retardant polyester resin (C), and characterized in that the phosphorus atom-containing flame retardant polyester resin (C) is obtained by a condensation reaction or a polycondensation reaction of a reactive phosphorus-containing compound (s) represented by the following structural formula (I).

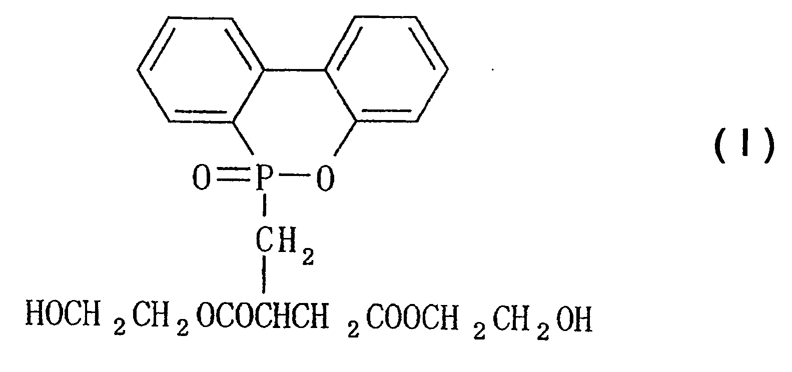

According to the present invention, since this flame retardant epoxy resin composition contains the phosphorus atom-containing flame retardant polyester resin (C), which does not contain halogen as the flame retardant, it is possible to impart high flame retardancy to the resin composition, reduce the amount of poisonous gas generated when ignited as a result of a reduction in halogen content in the resin composition, and provide good moldability. In addition, as described above, there are advantages that a cured product of the epoxy resin composition is excellent in heat resistance, water resistance, chemical resistance as well as flame retardancy, solder resistance, moisture resistance and tracking resistance.

It is preferred that a part or all of the curing agent (B) contains a novolac resin. In addition, it is preferred that an epoxy equivalent of the epoxy resin (A) is in a range of 100 to 10000 g/eq. In these cases, the crosslinking density of the cured product of the flame retardant epoxy resin composition increases, so that glass transition point "Tg", heat resistance and solder resistance are improved and particularly, performance needed in the laminate application is improved.

Moreover, it is preferred that the epoxy resin (A) consists of an epoxy resin having no halogen atom in its molecular structure. In this case, since the halogen content in the resin composition is further reduced, it is possible to more effectively prevent the generation of poisonous gas when ignited.

Another concern of the present invention is to provide a prepreg obtained by impregnating the flame retardant epoxy resin composition described above into a substrate, laminate obtained by molding the prepreg, and a printed wiring board obtained by forming a conductive wiring on a surface or both surfaces of the thus obtained laminate. These exhibit excellent flame retardancy by use of the halogen-free flame retardant. That is, since the prepreg, laminate and the printed wiring board are produced by use of the phosphorus atom-containing flame retardant polyester resin (C) as the flame retardant not containing halogen, it is possible to impart high flame retardancy to them, and reduce the amount of poisonous gas generated when ignited as a result of a reduction in halogen content in the resin composition. In addition, a molded article obtained by molding the prepreg, the laminate and the printed wiring board exhibit various excellent properties such as heat resistance, water resistance, chemical resistance, flame retardancy, solder resistance, moisture resistance and tracking resistance. It is preferred to form a metal foil on at least one surface of the laminate by laminate molding.

These and additional features of the present invention and advantages brought thereby will be understood from the base mode for carrying out the invention described below.

### BEST MODE FOR CARRYING OUT THE INVENTION

A flame retardant epoxy resin composition of the present invention, prepregs, laminates and printed wiring boards, which contain the same composition, are explained in detail according to preferred embodiments.

As described above, the flame retardant epoxy resin composition of the present invention is characterized by containing a phosphorus atom-containing flame retardant polyester resin (C) in an epoxy resin composition having an epoxy resin (A) and a curing agent (B) as essential components. In addition, to prepare the epoxy resin composition of the present invention, a halogen containing material can be used. However, it is preferred to prepare the flame retardant epoxy resin composition without using the halogen containing material. When preparing the halogen-free flame retardant epoxy resin composition, it is permitted that a small amount of the halogen containing material is inevitably mixed in the production process.

As the epoxy resin (A) used in the present invention, which is not specifically limited, it is preferred to use only a halogen-free compound. Such an epoxy resin (A) comprises, for example, a bisphenol type epoxy resin such as bisphenol A-type epoxy resin, bisphenol F-type epoxy resin, 2,2',6,6'-tetramethyl bisphenol A-type epoxy resin, bisphenol S-type epoxy resin, bisphenol AD-type epoxy resin, tetramethyl bisphenol A-type epoxy resin, and bis-β-trifluoromethyl diglycidyl bisphenol A-type epoxy resin; naphthalene type epoxy resin such as 1,6-diglycidyloxynaphthalene type epoxy resin, 1-(2,7-diglycidyloxynaphthyl)-1-(2-glycidyloxynaphthyl)methane, 1,1-bis(2,7-diglycidyloxynaphthyl)methane, and 1,1-bis(2,7-diglycidyloxynaphthyl)-1-phenyl-methane; other 2-functional epoxy resin such as bisphenol type epoxy resin, bisphenol hexafluoroacetone diglycidylether and resorcinol glycidylether; novolac type epoxy resin such as phenol novolac type epoxy resin, orthocresol novolac type epoxy resin, bisphenol A novolac type epoxy resin, and bisphenol AD novolac type epoxy resin; epoxy resin obtained by copolymerization between bisphenol type epoxy resin and novolac type epoxy resin through bisphenol; cyclic aliphatic epoxy resin typified by an epoxy compound of a polyaddition product of dicyclopentadiene and phenol; glycidyl ester type epoxy resin such as phthalic acid diglycidyl ester, tetrahydrophthalic acid diglycidyl ester, hexahydrophthalic acid diglycidyl ester, diglycidyl p-oxybenzoic acid ester, dimmer acid glycidyl ester, and triglycidyl ester; glycidylamine type epoxy resin such as tetraglycidyl aminodiphenylmethane, triglycidyl p-aminophenol, and tetraglycidyl m-xylylenediamine; heterocyclic epoxy resin such as hydantoin type epoxy resin and triglycidyl isocyanate; other epoxy resins such as phloroglucinol triglycidyl ether, trihydroxybiphenyl triglycidyl ether, trihydroxyphenylmethane triglycidyl ether, glycerin triglycidyl ether, 2-[4-(2,3-epoxy propoxy)phenyl]-2-[4-[1,1-bis[4-(2,3-epoxy propoxy)phenyl]ethyl]phenyl]propane, 1,3-bis[4-[1-[4-[(2,3 epoxy propoxy)phenyl]-1-[4-[1-[4-(2,3-epoxy propoxy)phenyl]-1-methylethyl]phenyl] ethyl]phenoxy]-2-propanol, tetrahydroxy phenylethane tetraglycidyl ether, tetraglycidyl benzophenone, bisresorcinol tetraglycidyl ether, and tetraglycidoxy biphenyl. Each of the epoxy resins listed above may be used by itself, or a combination of two or more thereof may be used. In addition, an epoxy resin obtained by denaturing the epoxy resin listed above may be used simultaneously.

In these epoxy resins, it is preferred that the epoxy equivalent is in a range of 100 to 10000 g/eq. That is, when the epoxy equivalent is not larger than 10000 g/eq, the crosslinking density of a cured product increases, and the glass transition temperature "Tg", heat resistance and the solder resistance are improved. In addition, an improvement in performance of the laminate is achieved.

In addition, it is preferred to use a novolac type epoxy resin as a part or all of the epoxy resin because a molded article having the high "Tg", high water resistance and the solder resistance is obtained. In the case of using the novolac type epoxy resin, it is particularly preferred that a content of the novolac type epoxy resin is 20 wt% or more with respect to the total amount of the epoxy resin (A). When the content is smaller than 20 wt%, it may be difficult to sufficiently impart the high Tg, high water resistance and the solder resistance to the molded article.

In the present invention, an epoxy reactive diluent such as cyclohexene oxide, tricyclodecene oxide and cyclopentene oxide may be used together with the epoxy resin (A).

As the curing agent (B), a curing agent generally used for epoxy resins is available. For example, it is possible to use a novolac resin; latent amine curing agent such as dicyandiamide, imidazole, BF₃-amine complex, and guanidine derivative; aromatic amine such as metaphenylenediamine, diaminodiphenylmethane, and diaminodiphenylsulfone; nitrogen atom containing curing agent such as cyclophosphazene oligomer; polyamide resin; acid anhydride curing agent such as maleic anhydride, phthalic anhydride, hexahydrophthalic anhydride and pyromellitic acid anhydride. Each of these curing agents (B) may be used by itself, or a combination of two or more thereof may be used.

In addition, it is preferred to use a novolac resin as a part or all of the curing agent (B). Such a novolac resin is not specifically limited. For example, it is possible to use the novolac resin, in which a phenol such as phenol, cresol, xylenol, ethylphenol, n-propylphenol, isopropylphenol, n-butylphenol, isobutylphenol, tertiary butylphenol, secondary butylphenol, n-hexylphenol, n-octylphenol, n-nonylphenol, n-dodecylphenol, isoamylphenol, isooctylphenol, tertiary aminophenol, tertiary octylphenol, and bisphenol A is crosslinked by formalin. From the viewpoint of excellent heat resistance, it is preferred to use a phenol novolac resin, in which phenol is crosslinked by formalin, or a cresol novolac resin, in which cresol is crosslinked by formalin.

In addition, it is preferred that a softening point of the novolac resin is in a range of 50 to 150 °C to achieve good balance between heat resistance and easiness of impregnation into a cloth-like substrate for electric laminate.

An additive amount of the curing agent (B) in the composition is determined in consideration of the kinds of components of the resin composition, moldability of prepregs, and the moldability of the prepregs at the time of curing and molding, and therefore not limited specifically. For example, when using the novolac resin as the curing agent (B), it is preferred that a hydroxyl equivalent of the novolac resin is in a range of 0.8 to 1.2 with respect to the epoxy resin (A). When the hydroxyl equivalent is out of this range, insufficient curing may happen.

If necessary, the epoxy resin composition of the present invention can contain a hardening accelerator. A conventional hardening accelerator is available. For example, it is possible to use a tertiary amine such as benzyldimethylamine, imidazole, organic acid metallic salt, Lewis acid, or an amine complex salt. Each of these compounds may be used by itself, or a combination of two or more thereof may be used. An additive amount of the hardening accelerator in the composition is determined in consideration of the kinds of components of the resin composition, moldability of prepregs, and the moldability of the prepregs at the time of curing and molding, and therefore not limited specifically. For example, it is preferred that the additive amount of the hardening accelerator is in a range of 0.001 to 10 wt% with respect to the total amount of the epoxy resin (A).

The phosphorus atom-containing flame retardant polyester resin (C) can be obtained by a condensation reaction or a polycondensation reaction of a reactive phosphorus-containing compound (s).

As the reactive phosphorus-containing compound (s), a compound represented by the following general formula (I) is preferably used from the viewpoints of easiness of reaction and excellent flame retardancy.

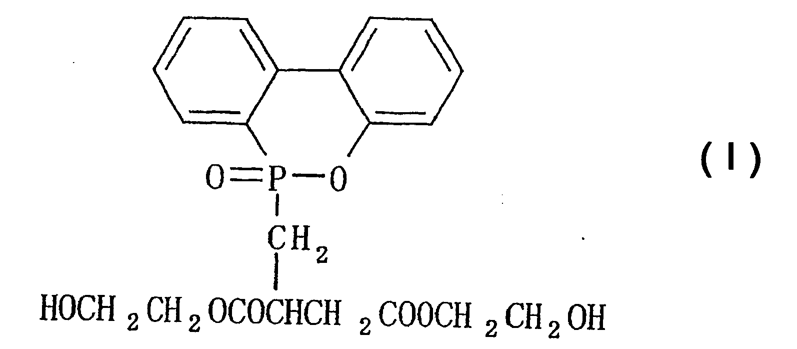

As described above, the phosphorus atom-containing flame retardant polyester resin (C) can be obtained by the condensation reaction or the polycondensation reaction of the reactive phosphorus-containing compound (s). Concretely speaking, the phosphorus atom-containing flame retardant polyester resin (C) can be obtained by adding the reactive phosphorus-containing compound (s) into a reaction vessel, gradually elevating the temperature, and then keeping it at a temperature range of 160 to 280 °C under a reduced pressure, for example, lower than 6.7 hPa (5 mmHg). In this reaction system, a conventional catalyst such as titanium, antimony, lead, zinc, magnesium, calcium, manganese, and alkali metal compounds may be added at an arbitrary timing.

It is preferred that the number average molecular weight of the phosphorus atom-containing flame retardant polyester resin (C) used in the epoxy resin composition of the present invention is in a range of 500 to 50000. When the number average molecular weight is in the above range, it is possible to provide the phosphorus atom-containing flame retardant polyester resin (C) having excellent flame retardancy, and impart remarkably improved flame retardancy and heat resistance to a cured product of the epoxy resin composition prepared by use of this phosphorus atom-containing flame retardant polyester resin (C).

A content of the phosphorus atom-containing flame retardant polyester resin (C) in the epoxy resin composition is not specifically limited. To obtain the epoxy resin composition having excellent tracking resistance, moisture resistance, solder resistance, heat resistance and flame retardancy of a cured product thereof, it is preferred to add the phosphorus atom-containing flame retardant polyester resin (C) such that a content of phosphorus atoms in the total amount of the composition (the phosphorus content based on phosphorus conversion) is 0.02 % or more by weight ratio. In this case, an upper limit of the content is not limited specifically. For example, it is preferred that the content of phosphorus atoms in the total amount of the composition is 9 % or less by weight ratio.

The epoxy resin composition of the present invention can contain a polyester resin other than the phosphorus atom-containing flame retardant polyester resin (C). In the case of adding the other polyester resin, it is preferred that the content of the phosphorus atom-containing flame retardant polyester resin (C) is 10 wt% or more with respect to the total amount of these polyester resins.

In addition, the epoxy resin composition of the present invention can contain an organic solvent (D) in addition to the components described above, if necessary. In particular, when preparing a varnish for electric laminates, it is preferred to use the components (A), (B), (C) and (D) as the essential components. Of course, even when the epoxy resin composition of the present invention is used for another applications such as a coating material, the component (D) may be used together with the components (A) to (C).

The organic solvent (D) is not specifically limited. For example, it is possible to use acetone, methylethylketone, toluene, xylene, methylisobutylketone, ethyl acetate, ethyleneglycol monomethylether, N,N-dimethylformaldehyde, methanol, ethanol, isopropylalcohol, n-butanol, methoxy propanol, ethyl carbitol, toluene or cyclohexanone. Each of these solvents may be used by itself, or a combination of two or more thereof may be used.

An amount used of the organic solvent (D) is not specifically limited. From the viewpoints of easiness of impregnation of the epoxy resin composition into a substrate in the case of preparing the prepreg and good adhesion between the resin composition and the substrate, it is preferred to add the organic solvent (D) such that a solid concentration in the varnish is 30 wt% or more, and particularly in a range of 40 to 70 wt%.

Furthermore, the epoxy resin composition of the present invention can contain various additives, flame retardant and a filler, if necessary. In particular, it is preferred to add an inorganic filler (E) to obtain further improved flame retardancy.

The inorganic filler (E) is not specifically limited. For example, it is possible to use silica, talc, calcium carbonate, magnesium carbonate, aluminum hydroxide, magnesium hydroxide, aluminum oxide, magnesium oxide, aluminum silicate, lithium aluminum silicate, barium titanate, barium sulfate, silicon nitride or boron nitride.

In addition, it is preferred to add the inorganic filler (E) such that a content of the inorganic filler (E) in the composition is 150 parts by weight or less with respect to 100 parts by weight of the total of the epoxy resin (A), curing agent (B) and the flame retardant (C). Even when using a larger amount of the inorganic filler (E) than 150 parts by weight, the flame retardancy is almost the same as above. On the contrary, deterioration in performance of the laminate such as drilling workability may happen.

Moreover, various kinds of additives such as penetrating agent and leveling agent may be added. However, to obtain remarkable effects of the present invention, it is recommended that the epoxy resin composition does not contain those additives. In the case of using those additives, it is preferred that the content in the resin composition is 5 wt% or less.

As described above, the epoxy resin composition of the present invention is particularly effective in the application of electric laminates. A method of manufacturing a laminate by use of the epoxy resin composition is not specifically limited. In the case of not using the organic solvent (D), for example, a solid composition prepared by the components of the epoxy resin composition is melted by heating, and the melted composition is impregnated into a substrate with a required resin content (preferably 30 to 70 wt%). On the other hand, when using the organic solvent (D), a varnish is prepared by compounding the components of the epoxy resin composition, and impregnated into the substrate with the required resin content (preferably 30 to 70 wt%) to obtain the prepreg. The laminate can be produced by hot pressing a required number (preferably 1 to 10) of the prepregs.

To obtain a metal clad laminate, for example, a metal foil(s) such as copper foil is placed on a surface or both surfaces of a required number (preferably, 1 to 10) of prepregs, and then the resultant assembly is hot pressed.

In addition, conductive wirings can be formed on a surface or both surfaces of the laminate or the metal clad laminate described above by a subtractive process or an additive process to obtain a printed wiring board.

The substrate used to prepare the prepreg is not specifically limited. For example, as the substrate available to prepare the prepreg, it is possible to use an inorganic fiber woven or nonwoven fabric such as a glass woven or nonwoven fabric or an organic fiber woven or nonwoven fabric such as an aramid resin woven or nonwoven fabric.

As pressure and temperature conditions at the time of forming the laminate, for example, it is preferred that the temperature is in a range of 120 to 220 °C, the pressure is in a range of 2 to 10 MPa, and the keep time is in a range of 10 to 240 minutes.

As described above, the epoxy resin composition of the present invention is very effective in the application for manufacturing the electric laminates. However, it is available in various applications such as adhesives, cast molding, and coatings by appropriately combining with the curing agent. For example, the resin composition can be applied as an adhesive on a copper foil, and then dried to obtain a semi-cured product, which is applicable in a buildup process.

Thus, according to the epoxy resin composition of the present invention, an anti-halogen, flame retardant cured product can be obtained without deteriorating the heat resistance. Therefore, it is suitable for various applications such as sealing, laminating and coating, and particularly for glass epoxy laminates or an IC sealing material. In addition, due to excellent adhesion with metals, it is possible to provide the epoxy resin composition for coating, which is suitable as resist and coating materials.

### (EXAMPLES)

Next, the present invention is explained according to Examples, which do not limit the invention. Unless otherwise specified, "parts" used in the following Synthesis Examples, Examples and Comparative Examples is based on weight. In addition, the number average molecular weight of polyester resins of the Synthesis Examples 1 to 3, physical properties in Examples 1 to 6 and Comparative Examples 1 to 3 were measured by the following methods.

### (1) Measurement of number average molecular weight

With respect to each of samples, a THF solution was prepared such that the solid content is 10 mg/ml, and the number average molecular weight was measured at an injection amount of 100 micro-liters under the following measuring conditions.
GPC measuring device: "SHODEX-SYSTEM 11" manufactured by SHOWA DENKO K.K.
Column: 4-series moving beds of SHODEX "KF-800P", "KF-805", "KF-803" and "KF-801" (all manufactured by SHOWA DENKO K.K.)

| | |
|---|---|
| THF Flow Amount: | 1ml/min |
| Column Temperature: | 45 °C |
| Detector: | RI |
| Conversion: | polystyrene |

### (2) Flame Retardancy

It was evaluated according to UL-94 flammability test method.

### (3) Tracking resistance

With respect to each of the samples, according to UL-1410, electrodes are disposed on a substrate, and a voltage corresponding to 50 drops was determined from an obtained titration number-voltage curve.

### (4) Peel Strength

It was evaluated according to JIS C 6481.

### (5) Heat Resistance

With respect to each of the samples, copper clad laminates having the size of 25 mm x 25mm were prepared as test pieces, and floated in a solder bath at 280 °C for different times of 5, 10, 15 and 20 minutes. Then, the occurrence of blister was checked according to the following criteria:
ⓞ : No blister occurred.
○ : Blister partially occurred.
Δ : Blister largely occurred.
× ; Blister occurred in the entire surface of the test piece.

### (6) Moisture Resistance

With respect to each of samples, after a pressurized steam treatment was performed under 2 atm at 120 °C, it was immersed in a solder bath at 280 °C for 10 seconds. Then, the occurrence of blister was checked according to the following criteria.
ⓞ : No blister occurred.
○ : Blister partially occurred.
Δ : Blister largely occurred.
× ; Blister occurred in the entire surface of the test piece.

### <Synthesis of phosphorus atom-containing flame retardant polyester resin (C)>

### (Synthesis Example 1)

600.0 parts of a reactive phosphorus-containing compound (s) (the reactive phosphorus-containing compound (s) represented by the above chemical formula (I), manufactured by SANKO CO., LTD, product name "M-ester", 63% ethylene glycol solution) and 0.1 parts of potassium titanium oxalate were added into a reaction vessel, and then heated, while being agitated. Next, the reaction vessel was gradually depressurized at 250 °C, and a copolymerization reaction proceeded for 50 minutes under conditions of 250 °C and 0.5 mmHg (66.7 Pa) to obtain a phosphorus atom-containing flame retardant polyester resin (C-1) having the number average molecular weight of 5100.

### (Synthesis Example 2)

In the synthesis Example 1, the copolymerization reaction proceeded for 10 minutes to obtain a phosphorus atom-containing flame retardant polyester resin (C-2) having the number average molecular weight of 520.

### (Synthesis Example 3)

In the synthesis Example 1, the copolymerization reaction proceeded for 180 minutes to obtain a phosphorus atom-containing flame retardant polyester resin (C-3) having the number average molecular weight of 11000.

### (Example 1)

100 parts of a phenol novolac type epoxy resin "EPICLON N-770" (manufactured by DAINIPPON INK AND CHEMICALS, INCORPORATED, epoxy equivalent 189g/eq), 70 parts of a bisphenol A-type epoxy resin "EPICLON 1051" (manufactured by DAINIPPON INK AND CHEMICALS, INCORPORATED, epoxy equivalent 470g/eq), 72 parts of a novolac type phenol resin "PSM-4261" (manufactured by Gunei Chemical Industry Co., Ltd., hydroxyl equivalent 106 g/eq, softening point 80°C) as a curing agent, 85 parts of the phosphorus atom-containing flame retardant polyester resin (C-1) obtained in the Synthetic Example 1, and 0.3 parts of 2-ethyl-4-methyl imidazole as a hardening accelerator were solved in a mixed solvent of 80 parts of methyl cellosolve and 90 parts of methyl ethyl ketone to prepare an epoxy resin composition (epoxy resin varnish).

The resin varnish was impregnated in a glass cloth (manufactured by Asahi-Schwebel Co., Ltd., Type-7628, Thickness: 0.18 mm), and then dried in B stage by a 170 °C drying machine, so that the gel time of the resultant prepreg measured at 170 °C is approximately 120 seconds. The thus obtained epoxy resin prepreg has a resin content of 45 wt%.

8 sheets of the obtained prepregs were stacked, and copper foils having a thickness of 18 µm were placed on both surfaces of the stacking. The resultant assembly was cured at the temperature of 170 °C under the pressure of 3.9 MPa (40 kg/cm²) for the heating time of 90 minutes to obtain a laminate having a thickness of about 1.6 mm.

With respect to the obtained laminate, the heat resistance (solder resistance), moisture resistance, peel strength were measured under the above-described measurement conditions. In addition, after the copper foils were removed from the laminate by dissolving, the tracking resistance and the flame retardancy were evaluated under the above measurement conditions. Results are shown in Table 1.

### (Example 2)

An epoxy resin composition was prepared according to the same method as Example 1 except for using the phosphorus atom-containing flame retardant polyester resin (C-2) obtained in the Synthetic Example 2 in place of the phosphorus atom-containing flame retardant polyester resin (C-1) obtained in the Synthetic Example 1. By use of the epoxy resin composition, epoxy resin prepregs and a laminate were produced and evaluated, as in the case of Example 1. Results are shown in Table 1.

### (Example 3)

An epoxy resin composition was prepared according to the same method as Example 1 except for using the phosphorus atom-containing flame retardant polyester resin (C-3) obtained in the Synthetic Example 3 in place of the phosphorus atom-containing flame retardant polyester resin (C-1) obtained in the Synthetic Example 1. By use of the epoxy resin composition, epoxy resin prepregs and a laminate were produced and evaluated, as in the case of Example 1. Results are shown in Table 1.

### (Example 4)

110 parts of a cresol novolac type epoxy resin "EPICLON N-665" (manufactured by DAINIPPON INK AND CHEMICALS, INCORPORATED, epoxy equivalent 206g/eq), 70 parts of a bisphenol A-type epoxy resin "EPICLON 1051" (manufactured by DAINIPPON INK AND CHEMICALS, INCORPORATED, epoxy equivalent 470g/eq), 72 parts of a novolac type phenol resin "PSM-4261" (manufactured by Gunei Chemical Industry Co., Ltd., hydroxyl equivalent 106 g/eq, softening point 80°C) as a curing agent, 85 parts of the phosphorus atom-containing flame retardant polyester resin (C-1) obtained in the Synthetic Example 1, and 0.3 parts of 2-ethyl-4-methyl imidazole as a hardening accelerator were solved in a mixed solvent of 80 parts of methyl cellosolve and 90 parts of methyl ethyl ketone to prepare an epoxy resin composition (epoxy resin varnish).

By use of the epoxy resin composition, epoxy resin prepregs and a laminate were produced and evaluated, as in the case of Example 1. Results are shown in Table 1.

### (Example 5)

An epoxy resin composition was prepared according to the same method as Example 4 except for using the phosphorus atom-containing flame retardant polyester resin (C-2) obtained in the Synthetic Example 2 in place of the phosphorus atom-containing flame retardant polyester resin (C-1) obtained in the Synthetic Example 1. By use of the epoxy resin composition, epoxy resin prepregs and a laminate were produced and evaluated, as in the case of Example 1. Results are shown in Table 1.

### (Example 6)

An epoxy resin composition was prepared according to the same method as Example 4 except for using the phosphorus atom-containing flame retardant polyester resin (C-3) obtained in the Synthetic Example 3 in place of the phosphorus atom-containing flame retardant polyester resin (C-1) obtained in the Synthetic Example 1. By use of the epoxy resin composition, epoxy resin prepregs and a laminate were produced and evaluated, as in the case of Example 1. Results are shown in Table 1.

### (Comparative Example 1)

100 parts of a phenol novolac type epoxy resin "EPICLON N-770" (manufactured by DAINIPPON INK AND CHEMICALS, INCORPORATED, epoxy equivalent 189g/eq), 70 parts of a bisphenol A-type epoxy resin "EPICLON 1051" (manufactured by DAINIPPON INK AND CHEMICALS, INCORPORATED, epoxy equivalent 470g/eq), 72 parts of a novolac type phenol resin "PSM-4261" (manufactured by Gunei Chemical Industry Co., Ltd., hydroxyl equivalent 106 g/eq, softening point 80°C), and 0.3 parts of 2-ethyl-4-methyl imidazole as a hardening accelerator were solved in a mixed solvent of 60 parts of methyl cellosolve and 70 parts of methyl ethyl ketone to prepare an epoxy resin composition (epoxy resin varnish). By use of the resin varnish, epoxy resin prepregs and a laminate were produced and evaluated, as in the case of Example 1. Results are shown in Table 1.

### (Comparative Example 2)

100 parts of a phenol novolac type epoxy resin "EPICLON N-770" (manufactured by DAINIPPON INK AND CHEMICALS, INCORPORATED, epoxy equivalent 189g/eq), 70 parts of a bisphenol A-type epoxy resin "EPICLON 1051" (manufactured by DAINIPPON INK AND CHEMICALS, INCORPORATED, epoxy equivalent 470g/eq), 72 parts of a novolac type phenol resin "PSM-4261" (manufactured by Gunei Chemical Industry Co., Ltd., hydroxyl equivalent 106 g/eq, softening point 80°C), 0.3 parts of 2-ethyl-4-methyl imidazole as a hardening accelerator, and 80 parts of a phosphate ester flame retardant "PX-200" (manufactured by DAIHACHI CHEMICAL INDUSTRY CO., LTD.) were solved in a mixed solvent of 80 parts of methyl cellosolve and 90 parts of methyl ethyl ketone to prepare an epoxy resin composition (epoxy resin varnish). By use of the resin varnish, epoxy resin prepregs and a laminate were produced and evaluated, as in the case of Example 1. Results are shown in Table 1.

### (Comparative Example 3)

100 parts of a phenol novolac type epoxy resin "EPICLON N-770" (manufactured by DAINIPPON INK AND CHEMICALS, INCORPORATED, epoxy equivalent 189g/eq), 70 parts of a bisphenol A-type epoxy resin "EPICLON 1051" (manufactured by DAINIPPON INK AND CHEMICALS, INCORPORATED, epoxy equivalent 470g/eq), 72 parts of a novolac type phenol resin "PSM-4261" (manufactured by Gunei Chemical Industry Co., Ltd., hydroxyl equivalent 106 g/eq, softening point 80°C), and 0.3 parts of 2-ethyl-4-methyl imidazole as a hardening accelerator were solved in a mixed solvent of 80 parts of methyl cellosolve and 90 parts of methyl ethyl ketone. In addition, 280 parts of an aluminum hydroxide powder (manufactured by Sumitomo Chemical Co., Ltd.) were added as an inorganic filler into a resultant mixture to prepare an epoxy resin composition (epoxy resin varnish). By use of the resin varnish, epoxy resin prepregs and a laminate were produced and evaluated, as in the case of Example 1. Results are shown in Table 1.

**(Table 1)**

| | Examples | | | | | | Comparative Examples | | |
|---|---|---|---|---|---|---|---|---|---|
| | 1 | 2 | 3 | 4 | 5 | 6 | 1 | 2 | 3 |
| Flame Retardancy [UL94] | V-0 | V-0 | V-0 | V-0 | V-0 | V-0 | V-2 | V-0 | V-0 |
| Tracking Resistance (V) | 600 | 600 | 600 | 600 | 600 | 600 | 600 | 200 | 500 |
| Peel Strength (kN/m) | 1.57 | 1.57 | 1.57 | 1.57 | 1.57 | 1.57 | 1.57 | 1.47 | 1.47 |
| Heat resistance | | | | | | | | | |
| 5 min | ⓞ | ⓞ | ⓞ | ⓞ | ⓞ | ⓞ | ⓞ | ⓞ | ⓞ |
| 10 min | ⓞ | ⓞ | ⓞ | ⓞ | ⓞ | ⓞ | ⓞ | ⓞ | ⓞ |
| 15 min | ⓞ | ⓞ | ⓞ | ⓞ | ⓞ | ⓞ | ⓞ | ○ | ⓞ |
| 20 min | ⓞ | ⓞ | ⓞ | ⓞ | ⓞ | ⓞ | ⓞ | Δ | ○ |
| Moisture Resistance | ⓞ | ⓞ | ⓞ | ⓞ | ⓞ | ⓞ | ⓞ | Δ | ○ |

### INDUSTIAL APPLICABILITY

As described above, according to the flame retardant epoxy resin composition of the present invention, since the phosphorus atom-containing flame retardant polyester resin (C) is used as the halogen-free flame retardant, it is possible to reduce the amount of poisonous gas generated when ignited. In addition, there is an advantage that a molded article obtained by molding this resin composition is excellent in flame retardancy, solder resistance, moisture resistance, and tracking resistance. The flame retardant epoxy resin composition of the present invention is particularly preferable to prepare prepregs, laminates and printed wiring boards.

## Claims

1. A flame retardant epoxy resin composition comprising an epoxy resin (A), curing agent (B) and a phosphorus atom-containing flame retardant polyester resin (C), wherein said phosphorus atom-containing flame retardant polyester resin (C) is obtained by a condensation reaction or a polycondensation reaction of a reactive phosphorus-containing compound (s) represented by the following structural formula (I).

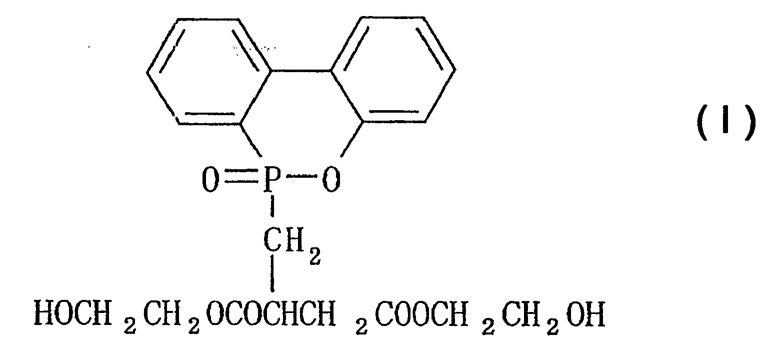

2. The flame retardant epoxy resin composition as set forth in claim 1, wherein a part or all of said curing agent (B) contains a novolac resin.

3. The flame retardant epoxy resin composition as set forth in claim 1, wherein an epoxy equivalent of said epoxy resin (A) is in a range of 100 to 10000 g/eq.

4. The flame retardant epoxy resin composition as set forth in claim 1, wherein said epoxy resin (A) consists of an epoxy resin having no halogen atom in its molecular structure.

5. A prepreg obtained by impregnating the flame retardant epoxy resin composition as set forth in claim 1 into a substrate.

6. A laminate obtained by molding the prepreg as set forth in claim 5.

7. The laminate as set forth in claim 6 further comprising a metal foil formed on at least one surface of the laminate by laminate molding.

8. A printed wiring board obtained by forming a conductive wiring on at least one surface of the laminate as set forth in claim 6.
